# EUROPEAN PATENT SPECIFICATION

(11) **EP 4 503 884 B1**
(45) Date of publication and mention of the grant of the patent: **22.07.2026**
(21) Application number: 23914277.1
(22) Date of filing: 04.08.2023
(51) Int. Cl.: H10B 12/00, H10D 88/00

(54) **SEMICONDUCTOR STRUCTURE AND MANUFACTURING METHOD THEREFOR**
HALBLEITERSTRUKTUR UND HERSTELLUNGSVERFAHREN DAFÜR
STRUCTURE SEMI-CONDUCTRICE ET SON PROCÉDÉ DE FABRICATION

(30) Priority: 03.01.2023 CN 202310007146
(43) Date of publication of application: 05.02.2025
(60) Divisional application: 26183651.4
(73) Proprietor: CXMT Corporation, Hefei, Anhui 230601 (CN)
(72) Inventor: WANG, Hong, Hefei, Anhui 230601 (CN); LI, Xiaojie, Hefei, Anhui 230601 (CN)
(74) Representative: Gulde & Partner
(86) International application number: PCT/CN2023/111130
(87) International publication number: WO 2024/146137

(56) References cited:
- CN-A- 112 908 882
- CN-A- 115 064 435
- CN-A- 115 064 435
- CN-A- 115 332 251
- US-A1- 2021 384 124
- US-A1- 2022 375 853

## Description

### CROSS-REFERENCE TO RELATED APPLICATIONS

This application claims priority to Chinese Patent Application No. 202310007146.8, filed on January 3, 2023, and entitled "SEMICONDUCTOR STRUCTURE AND METHOD OF MANUFACTURING THE SAME".

### TECHNICAL FIELD

The present disclosure relates to the field of semiconductor technologies, and in particular, to a semiconductor structure and a method of manufacturing the same.

### BACKGROUND

The scaling of conventionally structured DRAMs is approaching its limits. To further increase the integration density of DRAMs, it is crucial to develop innovative 3D DRAM structures. In a new 3D structure, leads need to be connected through staircase structure. In staircase structure in related technologies, metal layers connected to leads have different areas, resulting in an RC delay and affecting performance of a semiconductor structure. Related technologies are known from US 2021/384124 A1, US 2022/375853 A1, and CN 115 064 435 A.

### SUMMARY

The present disclosure is intended to provide a semiconductor structure and a method of manufacturing the same, so as to reduce a resistive-capacitive delay issue and improve performance of the semiconductor structure.

The invention is set out in the appended set of claims.

Therefore, according to the semiconductor structure and the method of manufacturing the same in the embodiments of the present disclosure, a first staircase structure is formed by forming multiple first staircase regions and etching the first staircase regions. Conductive layers are formed on the surfaces of the first staircase structure, and semiconductor layers under the conductive layers are removed, so that the conductive layers are all located on insulating stairs. Each conductive layer may be connected to the semiconductor layers with the same area. Conductive pillars subsequently formed are connected to the conductive layers. The conduction area of connections of the conductive pillars subsequently formed is the area of the semiconductor layers having the same area and the area of the conductive layers having the same area. As such, the difference between the conduction areas of the connections of the conductive pillars can be reduced and further the connection of each conductive pillar can be enabled to have the same conduction area by controlling the conductive layers to have the same area, thereby preventing a resistive-capacitive delay issue of the semiconductor structure and improving the performance of the semiconductor structure.

### BRIEF DESCRIPTION OF DRAWINGS

FIG. 1 is a flowchart of a method of manufacturing a semiconductor structure according to an embodiment of the present disclosure;
FIG. 2, FIG. 5, FIG. 8, FIG. 11, FIG. 14, FIG. 16, FIG. 18, and FIG. 20 are top views of steps of a method of manufacturing a semiconductor structure according to an embodiment of the present disclosure;
FIG. 3 is a cross-sectional view taken along the A-A line in FIG. 2; and FIG. 4 is a cross-sectional view taken along the B-B line in FIG. 2;
FIG. 6 is a cross-sectional view taken along the A-A line in FIG. 5; and FIG. 7 is a cross-sectional view taken along the B-B line in FIG. 5;
FIG. 9 is a cross-sectional view taken along the A-A line in FIG. 8; and FIG. 10 is a cross-sectional view taken along the B-B line in FIG. 8;
FIG. 12 is a cross-sectional view taken along the A-A line in FIG. 11; and FIG. 13 is a cross-sectional view taken along the B-B line in FIG. 11;
FIG. 15 is a cross-sectional view taken along the B-B line in FIG. 14; and FIG. 17 is a cross-sectional view taken along the B-B line in FIG. 16;
FIG. 19 is a cross-sectional view taken along the B-B line in FIG. 18; and FIG. 21 is a cross-sectional view taken along the B-B line in FIG. 20; and
FIG. 22 and FIG. 23 are cross-sectional views taken along the B-B lines of corresponding steps of a method of manufacturing a semiconductor structure after the step in FIG. 21 according to an embodiment of the present disclosure.

### Reference numerals:

1: substrate, 2: stacked structure, 21: first insulating layer, 22: semiconductor layer, 23: silicon germanium layer, 10: first staircase region, A1: first region, A2: second region, A3: third region, T1: 1^{st} staircase region, T2: 2^{nd} staircase region, T3: 3^{rd} staircase region, T4: 4^{th} staircase region, 31: first staircase structure, 32: second staircase structure, 41: first trench, 42: second insulating layer, 43: second trench, 44: fourth insulating layer, 51: shielding layer, 52: mask layer, 61: conductive layer, 62: conductive pillar, 63: third insulating layer, and 64: insulating support layer.

### DESCRIPTION OF EMBODIMENTS

A semiconductor structure and a method of manufacturing the same provided in the present disclosure are further described in detail below with reference to the accompanying drawings and specific implementations.

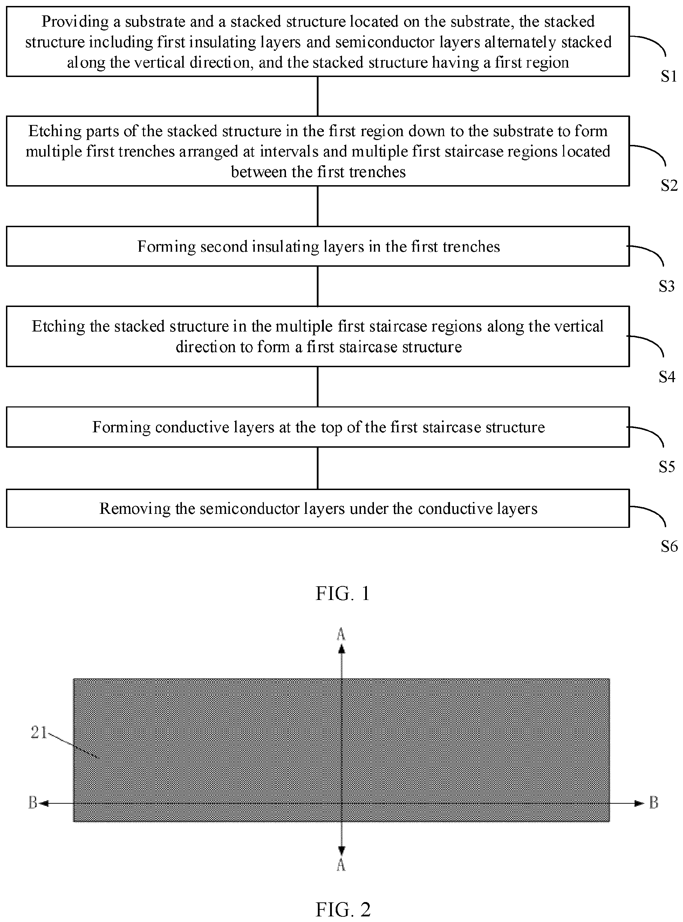

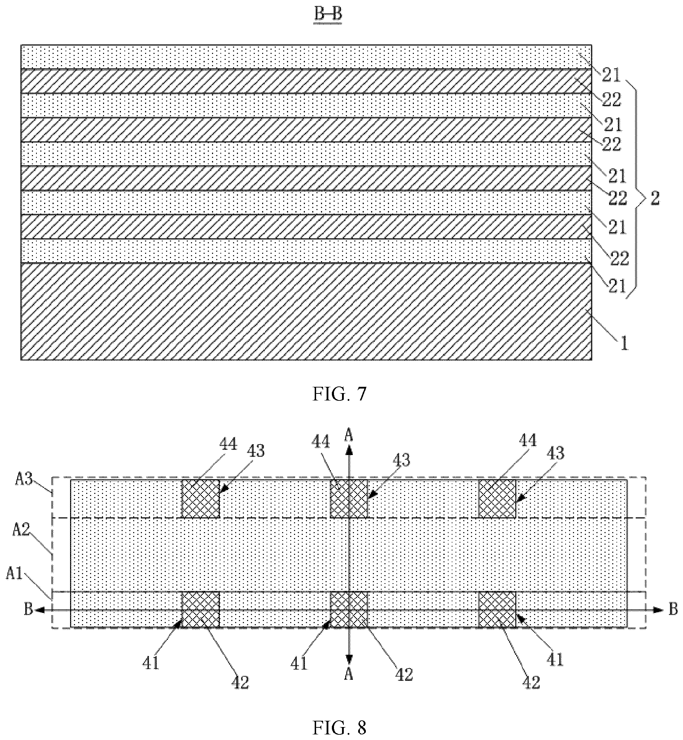

The method of manufacturing a semiconductor structure according to embodiments of the present disclosure is described below with reference to the accompanying drawings. FIG. 1 is a flowchart of a method of manufacturing a semiconductor structure according to embodiments of the present disclosure. As shown in FIG. 1, the method of manufacturing a semiconductor structure according to embodiments of the present disclosure may include the following steps: S1: a substrate 1 and a stacked structure 2 located on the substrate 1 are provided, the stacked structure 2 including first insulating layers 21 and semiconductor layers 22 alternately stacked along the vertical direction, and the stacked structure 2 having a first region A1 (with reference to FIG. 8); S2: parts of the stacked structure 2 in the first region A1 are etched down to the substrate 1 to form multiple first trenches 41 arranged at intervals and multiple first staircase regions 10 located between the first trenches 41; S3: second insulating layers 42 are formed in the first trenches 41; S4: the stacked structure 2 in the multiple first staircase regions 10 is etched along the vertical direction to form a first staircase structure 31; S5: conductive layers 61 are formed at the top of the first staircase structure 31; and S6: the semiconductor layers 22 under the conductive layers 61 are removed.

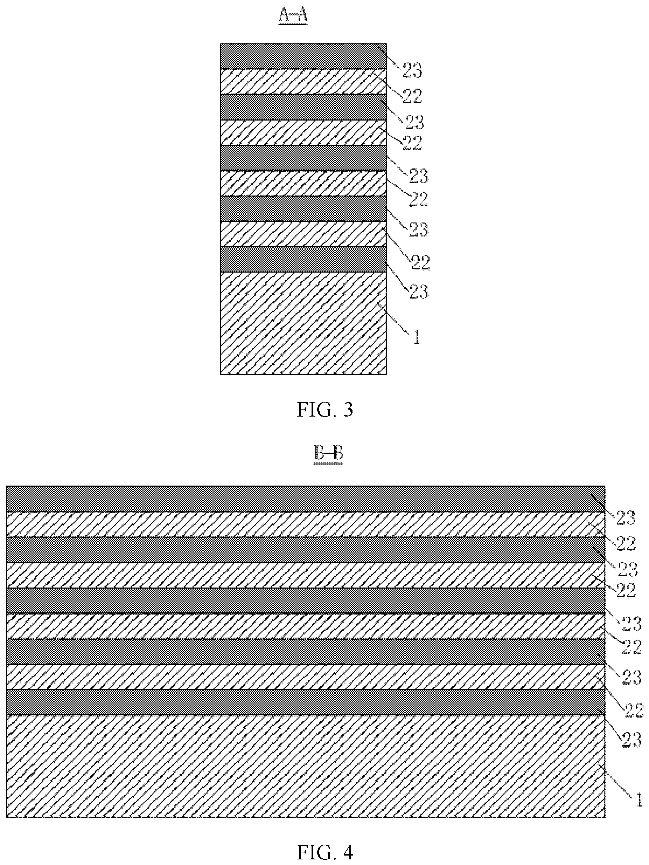

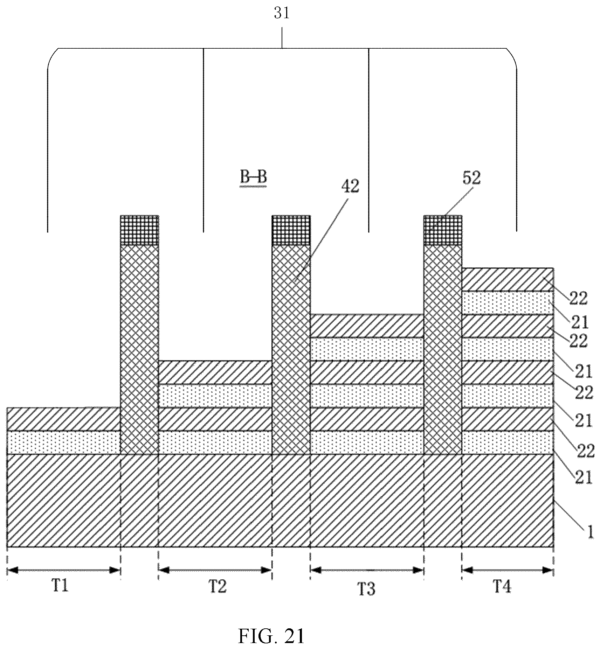

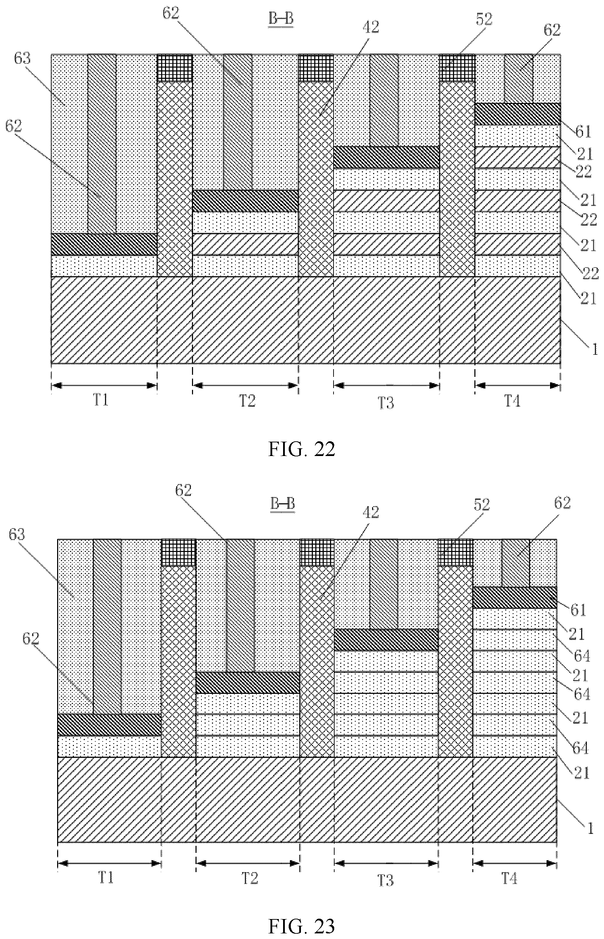

FIG. 2 to FIG. 23 are schematic structural diagrams corresponding to steps of the method of manufacturing a semiconductor structure according to embodiments of the present disclosure. FIG. 2, FIG. 5, FIG. 8, FIG. 11, FIG. 14, FIG. 16, FIG. 18, and FIG. 20 are top views of steps according to embodiments of the present disclosure. FIG. 3, FIG. 6, FIG. 9, and FIG. 12 are respectively cross-sectional views taken along the A-A lines in FIG. 2, FIG. 5, FIG. 8, and FIG. 11. FIG. 4, FIG. 7, FIG. 10, FIG. 13, FIG. 15, FIG. 17, FIG. 19, and FIG. 21 are respectively cross-sectional views taken along the B-B lines in FIG. 2, FIG. 5, FIG. 8, FIG. 11, FIG. 14, FIG. 16, FIG. 18, and FIG. 21. FIG. 22 to FIG. 23 are cross-sectional views taken along the B-B lines corresponding to steps of the method of manufacturing a semiconductor structure according to embodiments of the present disclosure after the step corresponding to FIG. 21. The vertical direction may be a direction perpendicular to the top surface of the substrate, and the horizontal direction may be a direction parallel to the top surface of the substrate.

As shown in FIG. 2 to FIG. 7, in the step of S1, the substrate 1 and the stacked structure 2 located on the substrate 1 are provided. The stacked structure 2 includes the first insulating layers 21 and the semiconductor layers 22 alternately stacked along the vertical direction, and the stacked structure 2 has the first region A1. The first region A1 may be configured to form staircase lead structures. The substrate 1 may be but is not limited to a silicon substrate 1. This specific implementation may be described by exemplifying the silicon substrate 1 as the substrate 1. In another embodiment, the substrate 1 may alternatively be a semiconductor substrate 1 such as gallium nitride, gallium arsenide, gallium carbide, silicon carbide, or SOI. The stacked structure 2 is formed on the substrate 1. The stacked structure 2 may include multiple first insulating layers 21 and multiple semiconductor layers 22. The semiconductor layers 22 and the first insulating layers 21 are alternately stacked one by one along the vertical direction. Optionally, the first insulating layers 21 may be oxide layers, e.g., silicon nitride layers, and the semiconductor layers 22 may have the same material as the substrate 1.

In some embodiments of the present disclosure, as shown in FIG. 2 to FIG. 7, the semiconductor layers 22 may be silicon layers, and the step that a substrate 1 and a stacked structure 2 located on the substrate 1 are provided may include the following steps:
the substrate 1 is provided;
multiple silicon layers and multiple silicon germanium layers 23 alternately distributed are formed on the substrate 1 by an epitaxial process;
the silicon germanium layers 23 are removed; and
the first insulating layers 21 are formed between the silicon layers to form the stacked structure 2.

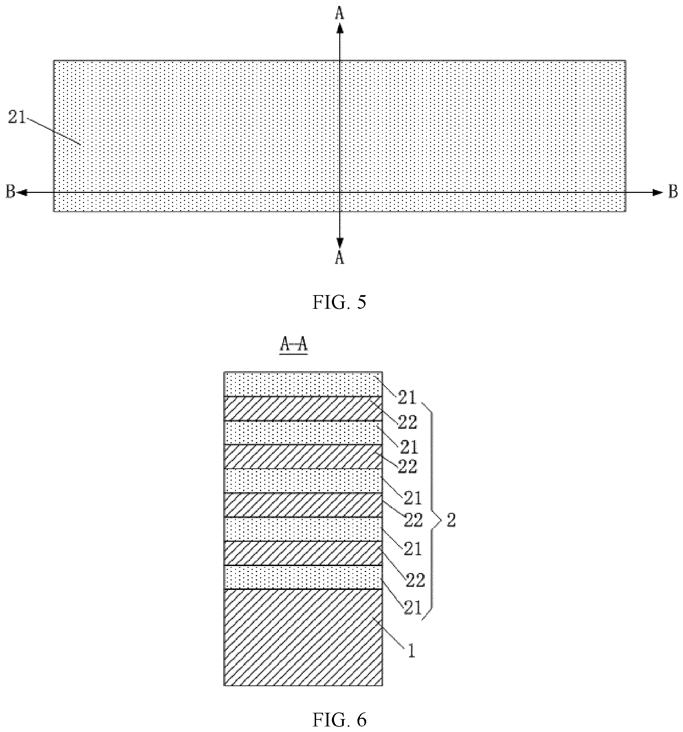

Specifically, as shown in FIG. 2 to FIG. 4, the substrate 1 is provided. The substrate 1 may be the silicon substrate 1 or the like. Description is provided in this specific implementation of the present disclosure by exemplifying the silicon substrate as the substrate 1. Then, sacrificial layers such as the silicon germanium layers 23 and the semiconductor layers 22 alternately distributed along the vertical direction are formed on the substrate 1 by the epitaxial growth process. The semiconductor layers 22 may be silicon layers. As shown in FIG. 5 to FIG. 7, the silicon germanium layers 23 may be removed, and subsequently the space formed after the silicon germanium layers 23 are removed may be filled in to form the first insulating layers 21. The first insulating layers 21 are formed between the silicon layers (the semiconductor layers 22), and are alternately distributed with the silicon layers along the vertical direction to form the stacked structure 2. Such practice features a simple process and can improve the preparation efficiency of the semiconductor structure.

In some other embodiments of the present disclosure, the stacked structure 2 may alternatively be formed deposited. For example, the first insulating layers 21 and the semiconductor layers 22 may be alternately deposited in sequence to form the stacked structure 2. The numbers of the semiconductor layers 22 and the first insulating layers 21 may be set according to an actual requirement, and the present disclosure sets no special limitations thereto. Optionally, the top layer of the stacked structure 2 may be the first insulating layer 21, and the bottom layer of the stacked structure 2 may be the first insulating layer 21, thereby protecting the semiconductor layers 22, preventing the semiconductor layers 22 from oxidization or contamination that may affect the performance of the semiconductor structure, and isolating the semiconductor layers 22 from the substrate 1. Further, the first insulating layer 21 may be an oxide layer, such as a silicon oxide layer.

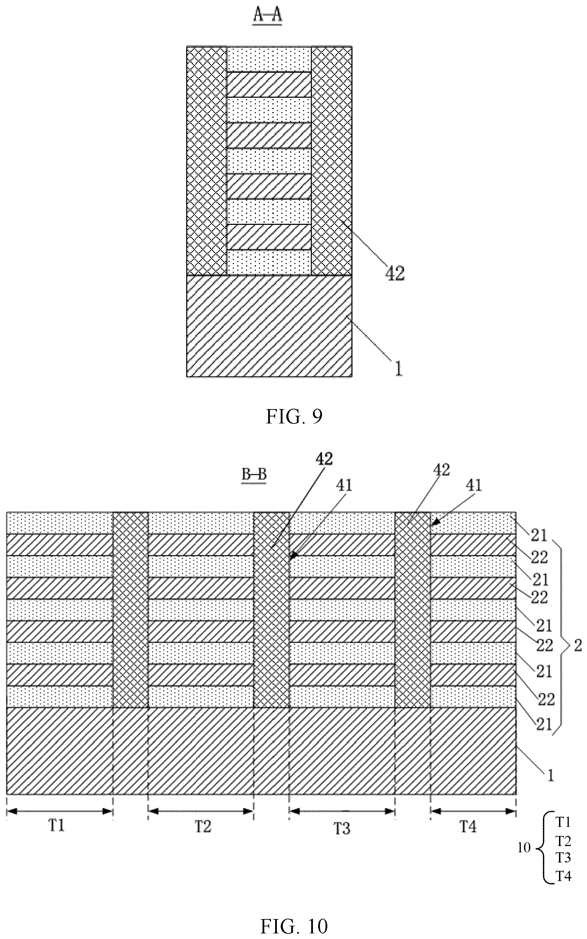

As shown in FIG. 8 to FIG. 10, in the step of S2, the parts of the stacked structure 2 in the first region A1 are etched down to the substrate 1 to form the multiple first trenches 41 arranged at intervals and the multiple first staircase regions 10 located between the first trenches 41; and in the step of S3, the second insulating layers 42 are formed in the first trenches 41. In this way, the multiple first staircase regions 10 (namely, a 1^{st} staircase region T1, a 2^{nd} staircase region T2, a 3^{rd} staircase region T3, and a 4^{th} staircase region T4 shown in FIG. 10) distributed at intervals can be formed by etching the stacked structure 2 in the first region A1, and the multiple first staircase regions 10 are separated by the first trenches 41. Then, the first trenches 41 are filled in with the second insulating layers 42, and the multiple first staircase regions 10 are isolated by the second insulating layers 42. As such, conductive structures of the multiple first staircase regions 10 are isolated when the conductive structures are subsequently formed in the first staircase regions 10.

In some specific embodiments of the present disclosure, the step that parts of the stacked structure 2 in the first region A1 are etched down to the substrate 1 may include the following steps:
a photoresist layer is formed on the surface of the stacked structure 2, the photoresist layer located in the first region A1 having etching holes defining locations of the first trenches 41;
the stacked structure 2 is etched along the etching holes to form the multiple first trenches 41, the first trenches 41 being uniformly distributed in the first region A1 along the horizontal direction, and the areas of the first staircase regions 10 between adjacent ones of the first trenches 41 being the same; and
the photoresist layer is removed.

Specifically, the photoresist layer may be formed on the upper surface of the stacked structure 2, and the photoresist layer is provided with the etching holes. The etching holes correspond to the locations, in the first region A1, configured to define the first trenches 41. Then, the stacked structure 2 may be etched along the etching holes down to the surface of the substrate 1 by at least one of wet etching or dry etching, so that the multiple first trenches 41 are formed in the stacked structure 2. As shown in FIG. 8 and FIG. 10, the multiple first trenches 41 may be uniformly distributed in the first region A1 along the horizontal direction, and the first staircase regions 10 are formed between adjacent ones of the first trenches 41, thereby enabling the first staircase regions 10 between the adjacent ones of the first trenches 41 to have the same area. As such, the conductive layers 61 formed in the first staircase regions 10 are enabled to have the same area when the conductive layers 61 are subsequently formed in the first staircase regions 10, so that the conductive layer 61 connected to each first staircase region 10 has the same area as the semiconductor layer 22, thereby preventing a resistance-capacitance (RC) delay issue caused by the difference between the areas of conductive structures connected to leads, and further improving the performance of the semiconductor structure.

As shown in FIG. 8 to FIG. 10, the photoresist layer may be removed afterwards, and the second insulating layers 42 may be formed in the first trenches 41 by at least one of a chemical vapor deposition method, a physical vapor deposition method, or atomic layer deposition, so that the multiple first staircase regions 10 are insulated and isolated from each other with the second insulating layers 42. Optionally, the second insulating layer 42 may be an oxide layer, a nitride layer, a nitride oxide layer, or a combined layer with a nitride layer and a nitride oxide layer being alternately distributed along the vertical direction, or a composite layer with a nitride layer and an oxide layer being alternately covered and stacked. For example, the second insulating layer 42 may be a silicon nitride layer or a silicon nitride oxide layer.

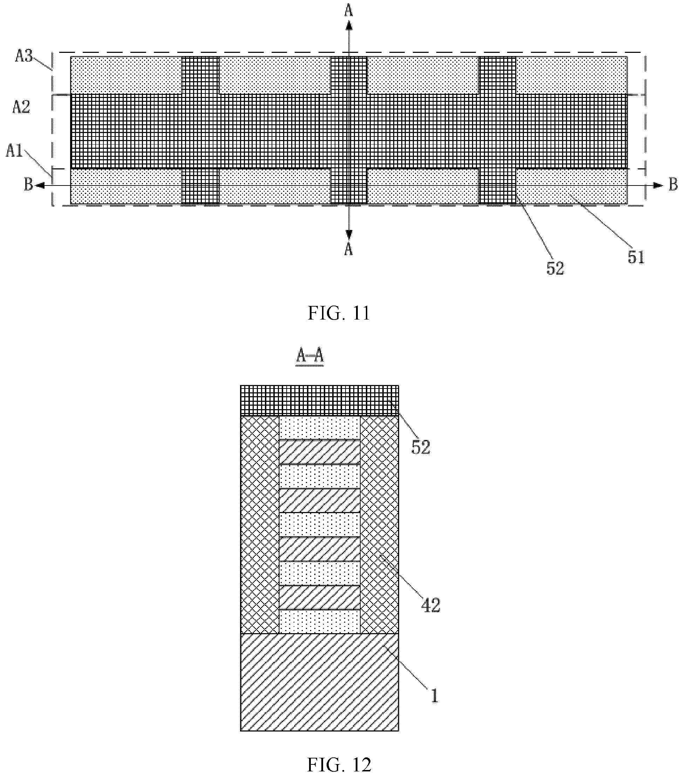

With reference to FIG. 11 to FIG. 21, in the step of S3, the stacked structure 2 in the multiple first staircase regions 10 is etched along the vertical direction to form the first staircase structure 31. The first staircase structure 31 corresponding to the multiple first staircase regions may have a height difference. To be specific, the upper surfaces of the first staircase structure 31 in the multiple first staircase regions are provided with different heights, and the different heights are staggered, so that the first staircase structure 31 corresponding to two adjacent first staircase regions 10 is provided with different heights. For example, the heights of the first staircase structure 31 corresponding to the multiple first staircase regions 10 may be distributed along the horizontal direction in a progressive increase or decrease manner, or the heights may be distributed in a staggered manner, thereby subsequently reducing the parasitic capacitance between the conductive pillars 62 on the first staircase structure 31 in adjacent first staircase regions 10.

In some embodiments of the present disclosure, as shown in FIG. 8 and FIG. 10, the multiple first staircase regions 10 may be successively the 1^{st} staircase region T1 to an N^{th} staircase region along the horizontal direction. As shown in FIG. 11 to FIG. 21, the step that the stacked structure 2 in the multiple first staircase regions is etched along the vertical direction to form a first staircase structure 31 may include the following step: the stacked structure in the multiple first staircase regions is etched successively along the horizontal direction and at least one layer among the first insulating layers 21 and the semiconductor layers 22 in the first staircase regions 10 is etched to form the first staircase structure 31, a j^{th} staircase region being etched simultaneously when a 1^{st} staircase region to a (j-1)^{th} staircase region being etched, 1 < j ≤ N, and j and N being integers greater than 1.

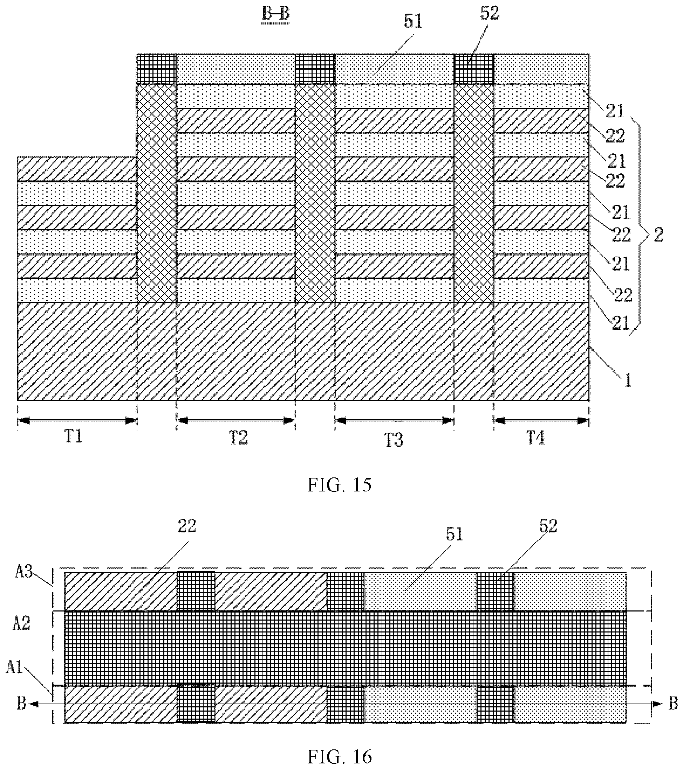

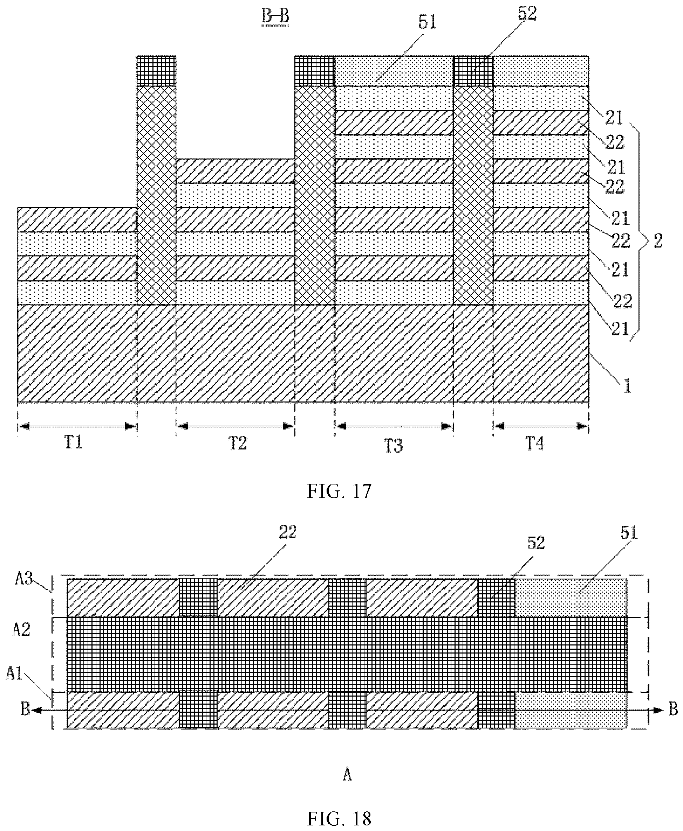

Specifically, as shown in FIG. 10, the first region A1 of the stacked structure 2 may include the multiple first staircase regions 10 along the horizontal direction, and the multiple first staircase regions 10 may include the 1^{st} staircase region T1, a 2^{nd} staircase region T2, ..., and the N^{th} staircase region along the horizontal direction. The 1^{st} staircase region T1, the 2^{nd} staircase region T2, ..., and the N^{th} staircase region may be successively etched when the multiple first staircase regions 10 are etched. All previously-etched first staircase regions are simultaneously etched when the next first staircase region 10 is being etched. For example, the 1^{st} staircase region T1 is etched, as shown in FIG. 11 to FIG. 15. Afterwards, the 2^{nd} staircase region T2 may be etched, and the 1^{st} staircase region T1 may be synchronously etched simultaneously when the 2^{nd} staircase region T2 is being etched, as shown in FIG. 16 to FIG. 17. As shown in FIG. 18 to FIG. 19, the 1^{st} staircase region T1 and the 2^{nd} staircase region T2 may be synchronously etched simultaneously when the 3^{rd} staircase region T3 is being etched, and so on. In this way, the 1^{st} staircase region T1 to the (j-1)^{th} staircase region may be etched simultaneously when the j^{th} staircase region is being etched, so that the stacked structure 2 obtained after etching the multiple first staircase regions 10 may be provided with a certain height difference to form the first staircase structure 31.

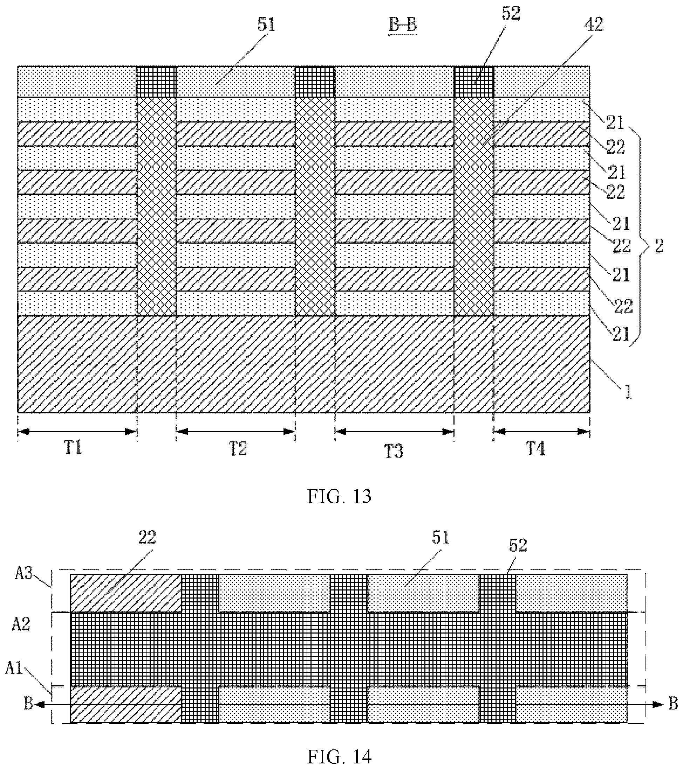

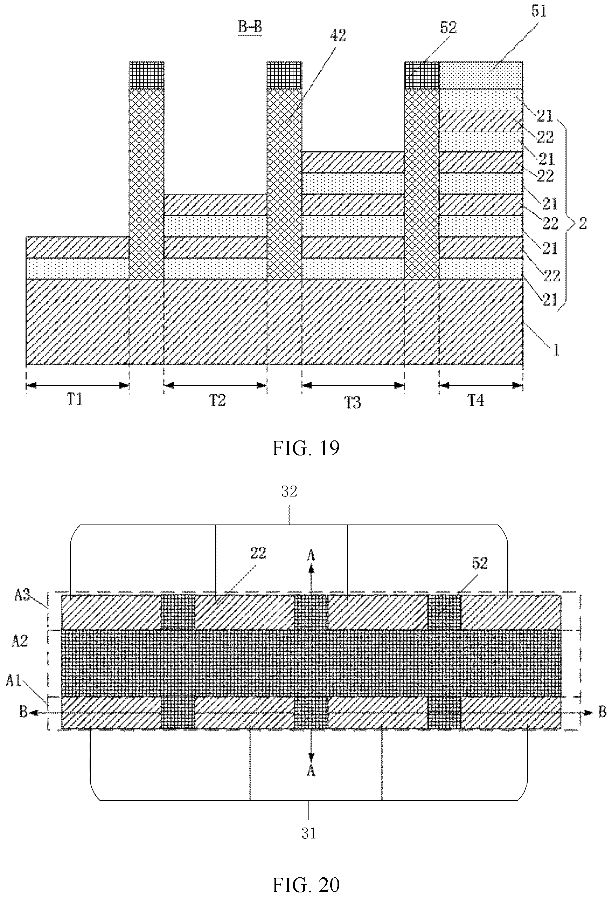

In the examples shown in FIG. 10 to FIG. 21, the multiple first staircase regions 10 may be four first staircase regions, namely, the 1^{st} staircase region T1, the 2^{nd} staircase region T2, the 3^{rd} staircase region T3, and the 4^{th} staircase region T4 distributed along the horizontal direction. As shown in FIG. 14 to FIG. 15, the 1^{st} staircase region T1 is etched. As shown in FIG. 16 to FIG. 17, the 1^{st} staircase region T1 is synchronously etched simultaneously when the 2^{nd} staircase region T2 is being etched. As shown in FIG. 18 to FIG. 19, the 1^{st} staircase region T1 and the 2^{nd} staircase region T2 are synchronously etched simultaneously when the 3^{rd} staircase region T3 is being etched. As shown in FIG. 20 to FIG. 21, the 4^{th} staircase region T4 is etched. The examples shown in the accompanying drawings of the present disclosure include four first staircase regions 10. Only the stacked structure 2 in the 4^{th} staircase region may be etched according to a practical situation when the 4^{th} staircase region is being etched, provided that a first staircase structure with a height difference can be formed. Certainly, it may be understood that, the 1^{st} staircase region T1, the 2^{nd} staircase region T2, and the 3^{rd} staircase region T3 may be synchronously etched when the first staircase region 10 is etched in the case that there are more first staircase regions 10, for example, more than four first staircase regions. At least one layer among the first insulating layers 21 and the semiconductor layers 22 in the first staircase region 10 may be etched each time the first staircase region 10 is etched so that, for example, the semiconductor layer 22 at a lower level can be exposed. In this way, the conductive layers 61 may be connected to the semiconductor layers 22 to facilitate electrical connection of the conductive layers 61 when the conductive layers 61 are subsequently formed at the top of the first staircase structure 31.

In some embodiments of the present disclosure, as shown in FIG. 14 to FIG. 21, the step that the stacked structure 2 in the multiple first staircase regions 10 is etched along the vertical direction includes the following step: at least one layer among the first insulating layers 21 and the semiconductor layers 22 in the stacked structure in each of the first staircase regions 10 is etched until the surface of a target semiconductor layer 22 is exposed. The conductive layer 61 may be formed on the target semiconductor layer 22 when the conductive layer 61 is subsequently formed, so that the conductive layer 61 can be electrically connected to the semiconductor layer 22. The target semiconductor layer 22 may be disposed according to an actual requirement, for example, may be disposed according to the number of layers in the stacked structure 2 or the number of stairs in the staircase structure.

In some embodiments of the present disclosure, as shown in FIG. 2, the stacked structure 2 further includes a second region A2 adjacent to the first region A1. As shown in FIG. 10 to FIG. 21, the step that the stacked structure 2 in the multiple first staircase regions 10 is etched along the vertical direction includes the following steps: a mask layer 52 is formed, the mask layer 52 being formed on the surfaces of the second insulating layers 42 and the surface of the second region A2 of the stacked structure 2; and the stacked structure 2 in the multiple first staircase regions 10 is etched successively along the vertical direction with the mask layer 52 serving as a mask.

Specifically, as shown in FIG. 2, the stacked structure 2 further includes the second region A2, and the first region A1 is disposed adjacent to the second region A2. The second region A2 may be configured to form a storage cell stacked structure including a word line structure or a bit line structure, and the first region A1 is configured to form the first staircase structure 31, so that the word line structure or the bit line structure located in the second region A2 can be led out.

As shown in FIG. 8 to FIG. 10, in the step that parts of the stacked structure 2 in the first region A1 are etched down to the substrate 1, the parts of the stacked structure 2 located in the second region A2 are not etched. In the step that the stacked structure 2 in the multiple first staircase regions is etched along the vertical direction, as shown in FIG. 11 to FIG. 13, the mask layer 52 may be formed on the surfaces of the second insulating layers 42 and the surface of the second region A2 of the stacked structure 2. Specifically, an initial mask layer may be formed on the surface of the stacked structure 2, and then the initial mask layer may be photoetched to remove parts of the initial mask layer located in the multiple first staircase regions and retain parts of the initial mask layer located on the surfaces of the second insulating layers 42 and the second region A2, thereby forming the mask layer 52 shielding the second insulating layers 42 and the parts of the stacked structure 2 in the second region A2. In this way, the first staircase regions are not covered by the mask layer 52. When the first staircase structure 31 is subsequently formed, the stacked structure 2 in the multiple first staircase regions may be successively etched along the vertical direction with the mask layer 52 serving as a mask. Optionally, the mask layer 52 may be a hard mask layer, for example, the mask layer 52 may be a silicon nitride oxide layer.

In some embodiments of the present disclosure, as shown in FIG. 11 to FIG. 21, the step that the stacked structure in the multiple first staircase regions is etched successively along the vertical direction with the mask layer 52 serving as a mask may include the following steps:
a shielding layer 51 is formed on the surfaces of the multiple first staircase regions 10; and
parts of the shielding layer 51 are etched and a portion of the shielding layer 51 on the surfaces of the staircase regions is retained before the stacked structure 2 in the first staircase regions 10 is etched.

As shown in FIG. 11 to FIG. 13, the multiple first staircase regions 10 are exposed after the mask layer 52 is formed on the second insulating layers 42 and the second region A2 of the stacked structure 2. The shielding layer 51 may be deposited on the surfaces of the first staircase regions by a deposition method. Optionally, the shielding layer 51 may be a low-K dielectric layer, e.g., a spinon hardmask (SOH) layer. The surface of the stacked structure 2 in the multiple first staircase regions 10 is covered by the shielding layer 51. The parts of the shielding layer 51 in the first staircase regions to be etched may be removed and a portion of the shielding layer 51 in the first staircase regions 10 may be retained before the stacked structure 2 in the first staircase regions 10 is etched. In this way, the parts of the stacked structure 2 in the first staircase regions 10 with the shielding layer 51 removed may be etched, without etching the stacked structure 2 in the first staircase regions 10 with the shielding layer 51 unremoved.

In some embodiments of the present disclosure, the multiple first staircase regions 10 may include the 1^{st} staircase region T1, the 2^{nd} staircase region T2, ..., the N^{th} staircase region along the horizontal direction. The shielding layer 51 on the surface of the j^{th} staircase region is removed and the shielding layer 51 on the surfaces of the (j+1)^{th} staircase region to the N^{th} staircase region is retained when the j^{th} staircase region is etched.

In the examples shown with reference to FIG. 2 to FIG. 21, the multiple first staircase regions 10 may include the 1^{st} staircase region T1, the 2^{nd} staircase region T2, the 3^{rd} staircase region T3, and the 4^{th} staircase region T4. As shown in FIG. 14 to FIG. 15, the shielding layer 51 located on the surface of the 1^{st} staircase region T1 may be removed and the shielding layer 51 located on the surfaces of the 2^{nd} staircase region T2, the 3^{rd} staircase region T3, and the 4^{th} staircase region T4 may be retained before the stacked structure 2 in the 1^{st} staircase region T 1 is etched. As shown in FIG. 16 to FIG. 17, the shielding layer 51 located in the 2^{nd} staircase region T2 is removed and the shielding layer 51 in the 3^{rd} staircase region T3 and the 4^{th} staircase region T4 is retained when the stacked structure 2 in the 2^{nd} staircase region T2 is etched. In this case, the stacked structure 2 in the 1^{st} staircase region T1 and the 2^{nd} staircase region T2 is exposed, so that the stacked structure 2 in the 1^{st} staircase region T1 and the 2^{nd} staircase region T2 is etched. As shown in FIG. 18 to FIG. 19, the shielding layer 51 in the 3^{rd} staircase region T3 is removed and the shielding layer 51 in the 4^{th} staircase region T4 is retained, so that the 1^{st} staircase region T1, the 2^{nd} staircase region T2, and the 3^{rd} staircase region T3 are exposed, and the stacked structure 2 in the 1^{st} staircase region T1, the 2^{nd} staircase region T2, and the 3^{rd} staircase region T3 may be synchronously etched. As shown in FIG. 20 to FIG. 21, the shielding layer 51 in the 4^{th} staircase region T4 is removed, so that the 1^{st} staircase region T1 to the 4^{th} staircase region T4 are exposed and that the 1^{st} staircase region T1 to the 4^{th} staircase region T4 can be synchronously etched.

As shown in FIG. 21 to FIG. 23, the step of S5 may be performed after the first staircase structure 31 is formed: the conductive layers 61 are formed at the top of the first staircase structure 31, and the conductive layers 61 may be connected to the semiconductor layers 22 to lead out signals.

In some embodiments of the present disclosure, the step that conductive layers 61 are formed at the top of the first staircase structure 31 may include the following step: the conductive layers 61 are deposited on the surfaces of the first staircase structure 31. In some examples, in the step that the first staircase structure 31 is formed, the stacked structure 2 in the first staircase regions 10 may be etched along the vertical direction down to the target semiconductor layer 22, and then the conductive layer 61 is formed on the surface of the target semiconductor layer 22. The conductive layer 61 is connected to a part of semiconductor layer 22 in the first staircase region 10 by contact, so as to be connected to the semiconductor layer 22 containing this part of semiconductor layer by contact. In some other examples of the present disclosure, in the step that the first staircase structure 31 is formed, the stacked structure 2 in the first staircase regions 10 may be etched along the vertical direction down to the surfaces of the first insulating layers 21. In the step that the conductive layers 61 are formed, the conductive layers 61 may be deposited on the surfaces of the first insulating layers 21. The conductive layers 61 may be connected to the sidewalls of the upper semiconductor layers 22 on the surfaces of the first insulating layers 21 by contact. The conductive layers 61 may have the same thickness as the semiconductor layers 22 after deposition.

In some other embodiments of the present disclosure, the semiconductor layers 22 are silicon layers, and the step that conductive layers 61 are formed at the top of the first staircase structure 31 includes the following steps: at least parts of the silicon layers are etched on the surfaces of the first staircase structure 31; and the conductive layers 61 are deposited on the surfaces of the silicon layers remaining in the first staircase structure 31. Specifically, after the first staircase structure 31 is formed, the top of the first staircase structure 31 is provided with the silicon layers. Then, dry etching or wet etching may be performed on the silicon layers to remove the parts of the silicon layers, and grooves may be formed on the surfaces of the silicon layers. Afterwards, the conductive layers 61 may be formed on the surfaces of the remaining silicon layers by a deposition method. The grooves formed after the parts of the silicon layers are removed are filled in by the conductive layers 61. The thickness of the conductive layers 61 and the thickness of the remaining silicon layers may be the same as the thickness of the silicon layers present before etching, so as to reduce a resistive-capacitive delay issue.

In still some other embodiments of the present disclosure, as shown in FIG. 22 to FIG. 23, the semiconductor layers 22 are silicon layers, and the step that conductive layers 61 are formed at the top of the first staircase structure 31 may include the following step: a metallization process is performed on the silicon layers at the top of the first staircase structure 31 to form the conductive layers 61. To be specific, the semiconductor layers 22 in the stacked structure 2 containing the silicon layers at the top of the first staircase structure 31 are partially silicified to form the conductive layers 61. The conductive layers 61 and the semiconductor layers 22 in the stacked structure 2 are the same silicon layers to implement connection by contact, and the conductive layers 61 are metal silicide layers to improve the electrical conductivity effect of the conductive layers 61.

As shown in FIG. 23, in the step of S6, the semiconductor layers 22 under the conductive layers 61 are removed. Specifically, the semiconductor layers 22 correspondingly located under the conductive layers 61 in the stacked structure 2 are removed. In other words, the semiconductor layers 22 located under the conductive layers 61 in the first region A1 are removed, so that the conductive layers 61 in the first staircase structure in the first region A1 are suspended. As such, the semiconductor layer 22 connected to the conductive layer 61 in each of the first staircase regions 10 is provided with the same area. For example, the semiconductor layer 22 connected to the conductive layer 61 in each of the first staircase regions 10 is located in the second region A2, thereby reducing the area difference between the conductive layer 61 in each of the first staircase regions 10 and the semiconductor layer 22 connected thereto by contact, and further reducing a resistive-capacitive delay issue of the semiconductor structure. In addition, the conductive layer 61 in each of the first staircase regions 10 and the semiconductor layer 22 in contact therewith can be enabled to have the same total area by controlling the conductive layers 61 in the multiple first staircase regions 10 to have the same area, thereby further reducing the resistive-capacitive delay issue of the semiconductor structure and improving the performance of the semiconductor structure.

In some embodiments of the present disclosure, the step that the semiconductor layers 22 under the conductive layers 61 are removed may include the following steps: etching grooves are formed, the etching grooves exposing the side surfaces of the first staircase structure 31 in the stacked structure 2; the semiconductor layers 22 in the first staircase structure 31 are removed along the etching grooves to form first gaps; and the etching grooves and the first gaps are filled in to form insulating support layers 64.

Specifically, the stacked structure 2 may be etched by an etching process to form the etching grooves. The stacked structure 2 may be etched along the sidewalls of the first staircase regions in the vertical direction. The sidewalls of the first staircase structure 31 are exposed by the etching grooves, and the semiconductor layers 22 located under the first staircase structure 31 are also exposed. The semiconductor layers 22 may be etched along the etching grooves to remove the semiconductor layers 22 located under the conductive layers 61, so that the first gaps are formed under the conductive layers 61. The etching rate may be controlled by controlling an etching parameter, such that the semiconductor layers 22 located under the conductive layers 61 and in the first staircase regions 10 are removed during the process of etching the semiconductor layers 22. Then, an insulating material is deposited to fill in the etching grooves and the first gaps to form the insulating support layers 64. The conductive layers 61 are formed on the insulating support layers 64 or the first insulating layers 21, thereby enabling the semiconductor layers 22 connected by contact to the conductive layer 61 in each of the first staircase regions 10 to have the same area.

In some embodiments of the present disclosure, as shown in FIG. 22 to FIG. 23, the method of manufacturing a semiconductor structure in the embodiments of the present disclosure may further include the following steps: third insulating layers 63 are formed on the surfaces of the conductive layers 61; conductive through holes exposing the conductive layers 61 are formed inside the third insulating layers 63 in the first staircase regions; and conductive pillars 62 are formed inside the conductive through holes, the conductive pillars 62 being connected to the conductive layers 61 by contact.

Specifically, the third insulating layers 63 are deposited on the surfaces of the semiconductor layers 22 by at least one of a chemical vapor deposition method, a physical vapor deposition method, and an atomic layer deposition method. The surfaces of the third insulating layers 63 may be flush with the surfaces of the second insulating layers 42. Then, the third insulating layers 63 may be etched to form the conductive through holes in the third insulating layers 63. The surfaces of the conductive layers 61 are exposed by the conductive through holes, and then the conductive pillars 62 may be deposited inside the conductive through holes, so that the conductive pillars 62 are connected to the conductive layers 61 by contact. Optionally, the step that the conductive pillars 62 are formed may include the following step: a conductive material may be deposited inside the conductive through holes and the surfaces of the third insulating layers 63, and then the conductive material located on the surfaces of the third insulating layers 63 is removed and the conductive material located inside the conductive through holes is retained to form the conductive pillars 62. The material of the conductive pillars 62 may be a metal material, for example, the material of the conductive pillars 62 may be metal tungsten.

In some embodiments of the present disclosure, as shown in FIG. 8, the stacked structure 2 may further include a third region A3 arranged at an interval from the first region A1, and the third region A3 may also be configured to form a staircase structure. In the example shown in FIG. 8, the third region A3 and the first region A1 are respectively located on both sides of the second region A2.

As shown in FIG. 8 to FIG. 21, the method further includes the following step simultaneously when the parts of the stacked structure 2 in the first region A1 are etched down to the substrate 1: the parts of the stacked structure 2 in the third region A3 are etched down to the substrate 1 to form multiple second trenches 43 arranged at intervals and multiple second staircase regions located between the second trenches 43; and the method further includes the following step simultaneously when the stacked structure 2 in the multiple first staircase regions is etched along the vertical direction to form the first staircase structure 31: the stacked structure 2 in the multiple second staircase regions is etched along the vertical direction to form a second staircase structure 32. In this way, the second staircase regions are etched simultaneously when the first staircase regions are etched to form the second staircase structure 32. The first staircase structure 31 and the second staircase structure 32 are synchronously formed, and a forming process of the second staircase structure 32 may be the same as that of the first staircase structure 31.

Specifically, in the step that the first trenches 41 are formed, the stacked structure 2 in the second region A2 may be simultaneously etched, so as to form the second trenches 43 in the second region A2. The second trenches 43 may be distributed at intervals along the horizontal direction of the second region A2, and the second staircase regions between adjacent ones of the second trenches 43 are provided with the same area. In the step that the second insulating layers 42 are formed inside the first trenches 41, as shown in FIG. 8, fourth insulating layers 44 may be simultaneously formed inside the second trenches 43, and the material of the fourth insulating layers 44 may be the same as that of the second insulating layers 42.

In the step that the first region A1 is etched to form the first staircase structure 31, the multiple second staircase regions may be simultaneously etched along the vertical direction to form the second staircase structure 32. The forming process of the second staircase structure 32 may be the same as that of the first staircase structure 31, thereby simplifying the process steps. Certainly, it may be understood that, alternatively, the first region A1 and the second region A2 may be separately etched, so that the first staircase structure 31 and the second staircase structure 32 with different shapes, different dimensions, or different height ranges may be formed. As such, the first staircase structure 31 and the second staircase structure 32 can be separately formed according to an actual requirement.

Further, in the subsequent step that the conductive layers 61 are formed, the conductive layers 61 may be simultaneously formed at the top of the second staircase structure 32, the semiconductor layers 22 under the conductive layers 61 in the second region A2 may be removed, and an insulating material may be filled in to form insulating stairs. In the step that the third insulating layers 63 and the conductive pillars 62 are formed, the third insulating layers 63 may be simultaneously formed on the surfaces of the conductive layers 61 in the second staircase structure 32. The conductive pillars 62 connected to the conductive layers 61 by contact may be formed in the third insulating layers 63 in the second region A2.

The present disclosure further provides a semiconductor structure. With reference to FIG. 2 to FIG. 23, the semiconductor structure according to embodiments of the present disclosure may include: a substrate 1 and a stacked structure 2, an insulating staircase structure, and conductive layers 61 located on the substrate 1. The stacked structure 2 includes a first region A1; the insulating staircase structure is located in the first region A1 and include multiple insulating stairs arranged at intervals, and the heights of any two insulating stairs are different; and the conductive layers 61 are located on the insulating stairs, respectively. Specifically, the conductive layers 61 may be connected to the conductive pillars 62 by contact to lead out signals, and adjacent insulating structures are provided with a height difference, thereby reducing the parasitic capacitance generated between the conductive pillars 62 formed on the adjacent insulating structures.

In some embodiments of the present disclosure, the semiconductor structure may further include multiple conductive pillars 62, and the multiple conductive pillars 62 are electrically connected to the conductive layers 61 to lead out signals of the stacked structure 2 through the conductive pillars 62.

In some embodiments of the present disclosure, the insulating stairs include first insulating layers 21 and insulating support layers 64 alternately arranged along a vertical direction.

In some embodiments of the present disclosure, the semiconductor structure further includes: second insulating layers 42. The second insulating layers 42 are located on the substrate 1 and located between adjacent ones of the insulating stairs, so as to isolate the conductive layers 61 and the conductive pillars 62 on the multiple insulating stairs.

In some embodiments of the present disclosure, the stacked structure 2 includes a second region A2 adjacent to the first region A1, the stacked structure 2 in the second region A2 includes the first insulating layers 21 and semiconductor layers 22 alternately stacked along the vertical direction, and the conductive layer 61 located on each of the insulating stairs is electrically connected to each of the semiconductor layers 22.

Therefore, according to the semiconductor structure and the method of manufacturing the same in the embodiments of the present disclosure, a first staircase structure 31 is formed by forming multiple first staircase regions and etching the first staircase regions. Conductive layers 61 are formed on the surfaces of the first staircase structure 31, and semiconductor layers 22 under the conductive layers 61 are removed, so that the conductive layers 61 are all located on insulating stairs. Each conductive layer 61 may be connected to the semiconductor layers 22 with the same area. Conductive pillars 62 subsequently formed are connected to the conductive layers 61. The conduction area of connections of the conductive pillars 62 subsequently formed is the area of the semiconductor layers 22 having the same area and the area of the conductive layers 61 having the same area. As such, the difference between the conduction areas of the connections of the conductive pillars 62 can be reduced and further the connection of each conductive pillar 62 can be enabled to have the same conduction area by controlling the conductive layers 61 to have the same area, thereby preventing the resistive-capacitive delay issue of the semiconductor structure and improving the performance of the semiconductor structure.

The foregoing descriptions are merely example implementations of the present disclosure.

## Claims

1. A method of manufacturing a semiconductor structure, comprising:
providing a substrate (1) and a stacked structure (2) located on the substrate (1), the stacked structure (2) comprising first insulating layers (21) and semiconductor layers (22) alternately stacked along a vertical direction, and the stacked structure (2) having a first region (A1);
etching parts of the stacked structure (2) in the first region (A1) down to the substrate (1) to form a plurality of first trenches (41) arranged at intervals and a plurality of first staircase regions (10) located between the first trenches (41);
forming second insulating layers (42) in the first trenches (41), the plurality of first staircase regions (10) being isolated from each other by the second insulating layers (42);
etching the stacked structure (2) in the plurality of first staircase regions (10) along the vertical direction to form a first staircase structure (31);
forming conductive layers (61) at a top of the first staircase structure (31); and
removing the semiconductor layers (22) under the conductive layers (61), and forming insulating support layers (64) filling in space from which the semiconductor layers (22) are removed, so that the first insulating layers (21) and the insulating support layers (64) under at least one of the conductive layers (61) are alternately arranged along the vertical direction, and only the first insulating layers (21) and the insulating support layers (64) are located between the at least one of the conductive layers (61) and the substrate (1).

2. The method of manufacturing a semiconductor structure according to claim 1, wherein the plurality of first staircase regions (10) are successively a 1^{st} staircase region to an N^{th} staircase region along a horizontal direction; and the etching the stacked structure (2) in the plurality of first staircase regions (10) along the vertical direction to form the first staircase structure (31) comprises:
etching the first staircase regions (10) successively along the horizontal direction and etching at least one layer among the first insulating layers (21) and the semiconductor layers (22) in the first staircase regions (10) to form the first staircase structure (31), a j^{th} staircase region being etched simultaneously when the 1^{st} staircase region to a (j-1)^{th} staircase region being etched, 1 < j ≤ N, and j and N being integers greater than 1.

3. The method of manufacturing a semiconductor structure according to any one of claims 1 to 2, wherein the etching parts of the stacked structure (2) in the first region (A1) down to the substrate (1) comprises:
forming a photoresist layer on a surface of the stacked structure (2), the photoresist layer located in the first region (A1) having etching holes defining locations of the first trenches (41);
etching the stacked structure (2) along the etching holes to form the plurality of first trenches (41), the first trenches (41) being uniformly distributed in the first region (A1) along the horizontal direction, and areas of the first staircase regions (10) between adjacent ones of the first trenches (41) being the same; and
removing the photoresist layer.

4. The method of manufacturing a semiconductor structure according to any one of claims 1 to 3, wherein the stacked structure (2) further comprises a second region (A2) adjacent to the first region (A1), and etching the stacked structure (2) in the plurality of first staircase regions (10) along the vertical direction comprises:
forming a mask layer (52), the mask layer (52) being formed on surfaces of the second insulating layers (42) and a surface of the second region (A2) of the stacked structure (2); and
etching the stacked structure (2) in the plurality of first staircase regions (10) successively along the vertical direction with the mask layer (52) serving as a mask.

5. The method of manufacturing a semiconductor structure according to claim 4, wherein etching the stacked structure (2) in the plurality of first staircase regions (10) successively along the vertical direction with the mask layer (52) serving as a mask comprises:
forming a shielding layer (51) on surfaces of the plurality of first staircase regions (10); and
etching parts of the shielding layer (51) and retaining a portion of the shielding layer (51) on the surfaces of the staircase regions before etching the stacked structure (2) in the first staircase regions (10).

6. The method of manufacturing a semiconductor structure according to any one of claims 1 to 5, wherein etching the stacked structure (2) in the plurality of first staircase regions (10) along the vertical direction comprises: etching at least one layer among the first insulating layers (21) and the semiconductor layers (22) in the stacked structure (2) in each of the first staircase regions (10) until exposing a surface of a target semiconductor layer.

7. The method of manufacturing a semiconductor structure according to any one of claims 1 to 6, wherein the semiconductor layers (22) are silicon layers, and forming the conductive layers (61) at the top of the first staircase structure (31) comprises: depositing the conductive layers (61) on surfaces of the first staircase structure (31); or
etching at least parts of the silicon layers on the surfaces of the first staircase structure (31); and depositing the conductive layers (61) on surfaces of the silicon layers remaining in the first staircase structure (31); or
performing a metallization process on the silicon layers at the top of the first staircase structure (31) to form the conductive layers (61).

8. The method of manufacturing a semiconductor structure according to any one of claims 1 to 7, wherein the method further comprises:
forming third insulating layers (63) on surfaces of the conductive layers (61);
forming, inside the third insulating layers (63) in the staircase regions, conductive through holes exposing the conductive layers (61); and
forming conductive pillars (62) inside the conductive through holes, the conductive pillars being connected to the conductive layers (61) by contact.

9. The method of manufacturing a semiconductor structure according to any one of claims 1 to 8, wherein the stacked structure (2) further comprises a third region (A3) arranged at an interval from the first region (A1), and the method further comprises the following step simultaneously when the parts of the stacked structure (2) in the first region (A1) are etched down to the substrate (1):
etching parts of the stacked structure (2) in the third region (A3) down to the substrate (1) to form a plurality of second trenches (43) arranged at intervals and a plurality of second staircase regions located between the second trenches (43); and
the method further comprises the following step simultaneously when the stacked structure (2) in the plurality of first staircase regions (10) is etched along the vertical direction to form the first staircase structure (31): etching the stacked structure (2) in the plurality of second staircase regions along the vertical direction to form a second staircase structure (32).

10. The method of manufacturing a semiconductor structure according to any one of claims 1 to 9, wherein removing the semiconductor layers (22) under the conductive layers (61), and forming insulating support layers (64) filling in space from which the semiconductor layers (22) are removed, comprises:
forming etching grooves, the etching grooves exposing side surfaces of the first staircase structure (31) in the stacked structure (2);
removing the semiconductor layers (22) in the first staircase structure (31) along the etching grooves to form first gaps; and
filling in the etching grooves and the first gaps to form insulating support layers (64).

11. A semiconductor structure, comprising:
a substrate (1) and a stacked structure (2) located on the substrate (1), the stacked structure (2) comprising a first region (A1);
an insulating staircase structure, the insulating staircase structure being located in the first region (A1) and comprising a plurality of insulating stairs arranged at intervals, and heights of any two insulating stairs being different, a height of each insulating stair being a distance from an upper surface of the substrate (1) to an upper surface of the each insulating stair; and
conductive layers (61), the conductive layers (61) being located on the insulating stairs, respectively,
wherein the insulating stair under at least one of the conductive layers comprises first insulating layers (21) and insulating support layers (64) alternately arranged along a vertical direction, and only the first insulating layers (21) and the insulating support layers (64) are located between the at least one of the conductive layers (61) and the substrate (1);
**characterized in that** the semiconductor structure further comprises:
second insulating layers (42), the second insulating layers (42) being located on the substrate (1) and located between adjacent ones of the insulating stairs; wherein the plurality of insulating stairs are isolated from each other by the second insulating layers.

12. The semiconductor structure according to claim 11, further comprising:
a plurality of conductive pillars (62), the plurality of conductive pillars (62) being electrically connected to the conductive layers (61), respectively.

13. The semiconductor structure according to claim 11 or 12, wherein the stacked structure (2) comprises a second region (A2) adjacent to the first region (A1), the stacked structure (2) in the second region (A2) comprises the first insulating layers (21) and semiconductor layers (22) alternately stacked along the vertical direction, and the conductive layer (61) located on each of the insulating stairs is electrically connected to each of the semiconductor layers (22).

## Patentansprüche

1. Verfahren zur Herstellung einer Halbleiterstruktur, umfassend:
Bereitstellen eines Substrats (1) und einer auf dem Substrat (1) befindlichen Stapelstruktur (2), wobei die Stapelstruktur (2) erste Isolierschichten (21) und Halbleiterschichten (22) umfasst, die abwechselnd entlang einer vertikalen Richtung gestapelt sind, und wobei die Stapelstruktur (2) einen ersten Bereich (A1) aufweist;
Ätzen von Teilen der Stapelstruktur (2) im ersten Bereich (A1) bis zum Substrat (1), um eine Vielzahl von ersten Gräben (41), die in Abständen angeordnet sind, und eine Vielzahl von ersten Stufenbereichen (10), die sich zwischen den ersten Gräben (41) befinden, auszubilden;
Ausbilden von zweiten Isolierschichten (42) in den ersten Gräben (41), wobei die Vielzahl von ersten Stufenbereichen (10) voneinander durch die zweiten Isolierschichten (42) isoliert sind;
Ätzen der Stapelstruktur (2) in der Vielzahl von ersten Stufenbereichen (10) entlang der vertikalen Richtung, um eine erste Stufenstruktur (31) auszubilden;
Ausbilden von leitfähigen Schichten (61) an einer Oberseite der ersten Stufenstruktur (31); und
Entfernen der Halbleiterschichten (22) unter den leitfähigen Schichten (61) und Ausbilden von isolierenden Stützschichten (64), die einen Raum füllen, aus dem die Halbleiterschichten (22) entfernt wurden, sodass die ersten Isolierschichten (21) und die isolierenden Stützschichten (64) unter mindestens einer der leitfähigen Schichten (61) abwechselnd entlang der vertikalen Richtung angeordnet sind, und wobei sich nur die ersten Isolierschichten (21) und die isolierenden Stützschichten (64) zwischen der mindestens einen der leitfähigen Schichten (61) und dem Substrat (1) befinden.

2. Verfahren zur Herstellung einer Halbleiterstruktur nach Anspruch 1, wobei die Vielzahl von ersten Stufenbereichen (10) nacheinander ein 1. Stufenbereich bis ein N-ter Stufenbereich entlang einer horizontalen Richtung sind; und wobei das Ätzen der Stapelstruktur (2) in der Vielzahl von ersten Stufenbereichen (10) entlang der vertikalen Richtung, um die erste Stufenstruktur (31) auszubilden, umfasst:
Ätzen der ersten Stufenbereiche (10) nacheinander entlang der horizontalen Richtung und Ätzen mindestens einer Schicht aus den ersten Isolierschichten (21) und den Halbleiterschichten (22) in den ersten Stufenbereichen (10), um die erste Stufenstruktur (31) auszubilden, wobei ein j-ter Stufenbereich gleichzeitig geätzt wird, wenn der 1. Stufenbereich bis zu einem (j-1)-ten Stufenbereich geätzt wird, 1 < j ≤ N, und wobei j und N Ganzzahlen größer als 1 sind.

3. Verfahren zur Herstellung einer Halbleiterstruktur nach einem der Ansprüche 1 bis 2, wobei das Ätzen von Teilen der Stapelstruktur (2) im ersten Bereich (A1) bis zum Substrat (1) umfasst:
Ausbilden einer Fotoresistschicht auf einer Oberfläche der Stapelstruktur (2), wobei die Fotoresistschicht, die sich in dem ersten Bereich (A1) befindet, Ätzlöcher aufweist, die Positionen der ersten Gräben (41) definieren;
Ätzen der Stapelstruktur (2) entlang der Ätzlöcher, um die Vielzahl von ersten Gräben (41) auszubilden, wobei die ersten Gräben (41) im ersten Bereich (A1) entlang der horizontalen Richtung gleichmäßig verteilt sind und wobei Flächen der ersten Stufenbereiche (10) zwischen benachbarten der ersten Gräben (41) gleich sind; und
Entfernen der Fotoresistschicht.

4. Verfahren zur Herstellung einer Halbleiterstruktur nach einem der Ansprüche 1 bis 3, wobei die Stapelstruktur (2) ferner einen zweiten Bereich (A2) benachbart zu dem ersten Bereich (A1) umfasst, und wobei das Ätzen der Stapelstruktur (2) in der Vielzahl von ersten Stufenbereichen (10) entlang der vertikalen Richtung umfasst:
Ausbilden einer Maskenschicht (52), wobei die Maskenschicht (52) auf Oberflächen der zweiten Isolierschichten (42) und einer Oberfläche des zweiten Bereichs (A2) der Stapelstruktur (2) ausgebildet wird; und
Ätzen der Stapelstruktur (2) in der Vielzahl von ersten Stufenbereichen (10) nacheinander entlang der vertikalen Richtung, wobei die Maskenschicht (52) als eine Maske dient.

5. Verfahren zur Herstellung einer Halbleiterstruktur nach Anspruch 4, wobei das Ätzen der Stapelstruktur (2) in der Vielzahl von ersten Stufenbereichen (10) nacheinander entlang der vertikalen Richtung, wobei die Maskenschicht (52) als eine Maske dient, umfasst:
Ausbilden einer Abschirmschicht (51) auf Oberflächen der Vielzahl von ersten Stufenbereichen (10); und
Ätzen von Teilen der Abschirmschicht (51) und Beibehalten eines Abschnitts der Abschirmschicht (51) auf den Oberflächen der Stufenbereiche vor dem Ätzen der Stapelstruktur (2) in den ersten Stufenbereichen (10).

6. Verfahren zur Herstellung einer Halbleiterstruktur nach einem der Ansprüche 1 bis 5, wobei das Ätzen der Stapelstruktur (2) in der Vielzahl von ersten Stufenbereichen (10) entlang der vertikalen Richtung umfasst: Ätzen mindestens einer Schicht aus den ersten Isolierschichten (21) und den Halbleiterschichten (22) in der Stapelstruktur (2) in jedem der ersten Stufenbereiche (10) bis zum Freilegen einer Oberfläche einer Ziel-Halbleiterschicht.

7. Verfahren zur Herstellung einer Halbleiterstruktur nach einem der Ansprüche 1 bis 6, wobei die Halbleiterschichten (22) Siliziumschichten sind, und wobei das Ausbilden der leitfähigen Schichten (61) an der Oberseite der ersten Stufenstruktur (31) umfasst: Abscheiden der leitfähigen Schichten (61) auf Oberflächen der ersten Stufenstruktur (31); oder
Ätzen von mindestens Teilen der Siliziumschichten auf den Oberflächen der ersten Stufenstruktur (31); und Abscheiden der leitfähigen Schichten (61) auf Oberflächen der in der ersten Stufenstruktur (31) verbleibenden Siliziumschichten; oder
Durchführen eines Metallisierungsverfahrens auf den Siliziumschichten an der Oberseite der ersten Stufenstruktur (31), um die leitfähigen Schichten (61) auszubilden.

8. Verfahren zur Herstellung einer Halbleiterstruktur nach einem der Ansprüche 1 bis 7, wobei das Verfahren ferner umfasst:
Ausbilden von dritten Isolierschichten (63) auf Oberflächen der leitfähigen Schichten (61);
Ausbilden von leitfähigen Durchgangslöchern innerhalb der dritten Isolierschichten (63) in den Stufenbereichen, wobei die leitfähigen Durchgangslöcher die leitfähigen Schichten (61) freilegen; und
Ausbilden von leitfähigen Säulen (62) innerhalb der leitfähigen Durchgangslöcher, wobei die leitfähigen Säulen durch Kontakt mit den leitfähigen Schichten (61) verbunden sind.

9. Verfahren zur Herstellung einer Halbleiterstruktur nach einem der Ansprüche 1 bis 8, wobei die Stapelstruktur (2) ferner einen dritten Bereich (A3) umfasst, der in einem Abstand von dem ersten Bereich (A1) angeordnet ist, und wobei das Verfahren ferner gleichzeitig mit dem Ätzen der Teile der Stapelstruktur (2) im ersten Bereich (A1) bis zum Substrat (1) den folgenden Schritt umfasst:
Ätzen von Teilen der Stapelstruktur (2) im dritten Bereich (A3) bis zum Substrat (1), um eine Vielzahl von zweiten Gräben (43), die in Abständen angeordnet sind, und eine Vielzahl von zweiten Stufenbereichen, die sich zwischen den zweiten Gräben (43) befinden, auszubilden; und
wobei das Verfahren ferner gleichzeitig mit dem Ätzen der Stapelstruktur (2) in der Vielzahl von ersten Stufenbereichen (10) entlang der vertikalen Richtung zum Ausbilden der ersten Stufenstruktur (31) den folgenden Schritt umfasst: Ätzen der Stapelstruktur (2) in der Vielzahl von zweiten Stufenbereichen entlang der vertikalen Richtung, um eine zweite Stufenstruktur (32) auszubilden.

10. Verfahren zur Herstellung einer Halbleiterstruktur nach einem der Ansprüche 1 bis 9, wobei das Entfernen der Halbleiterschichten (22) unter den leitfähigen Schichten (61) und das Ausbilden von isolierenden Stützschichten (64), die einen Raum füllen, aus dem die Halbleiterschichten (22) entfernt wurden, umfasst:
Ausbilden von Ätznuten, wobei die Ätznuten Seitenoberflächen der ersten Stufenstruktur (31) in der Stapelstruktur (2) freilegen;
Entfernen der Halbleiterschichten (22) in der ersten Stufenstruktur (31) entlang der Ätznuten, um erste Spalte auszubilden; und
Füllen der Ätznuten und der ersten Spalte, um isolierende Stützschichten (64) auszubilden.

11. Halbleiterstruktur, umfassend:
ein Substrat (1) und eine auf dem Substrat (1) befindliche Stapelstruktur (2), wobei die Stapelstruktur (2) einen ersten Bereich (A1) umfasst;
eine isolierende Stufenstruktur, wobei sich die isolierende Stufenstruktur im ersten Bereich (A1) befindet und eine Vielzahl von in Abständen angeordneten isolierenden Stufen umfasst, und wobei Höhen von beliebigen zwei isolierenden Stufen verschieden sind, wobei eine Höhe jeder isolierenden Stufe ein Abstand von einer oberen Oberfläche des Substrats (1) zu einer oberen Oberfläche der jeweiligen isolierenden Stufe ist; und
leitfähige Schichten (61), wobei sich die leitfähigen Schichten (61) jeweils auf den isolierenden Stufen befinden,
wobei die isolierende Stufe unter mindestens einer der leitfähigen Schichten erste Isolierschichten (21) und isolierende Stützschichten (64) umfasst, die abwechselnd entlang einer vertikalen Richtung angeordnet sind, und wobei sich nur die ersten Isolierschichten (21) und die isolierenden Stützschichten (64) zwischen der mindestens einen der leitfähigen Schichten (61) und dem Substrat (1) befinden;
**dadurch gekennzeichnet, dass** die Halbleiterstruktur ferner umfasst:
zweite Isolierschichten (42), wobei sich die zweiten Isolierschichten (42) auf dem Substrat (1) befinden und zwischen benachbarten der isolierenden Stufen angeordnet sind; wobei die Vielzahl von isolierenden Stufen voneinander durch die zweiten Isolierschichten isoliert sind.

12. Halbleiterstruktur nach Anspruch 11, ferner umfassend:
eine Vielzahl von leitfähigen Säulen (62), wobei die Vielzahl von leitfähigen Säulen (62) jeweils mit den leitfähigen Schichten (61) elektrisch verbunden sind.

13. Halbleiterstruktur nach Anspruch 11 oder 12, wobei die Stapelstruktur (2) einen zum ersten Bereich (A1) benachbarten zweiten Bereich (A2) umfasst, wobei die Stapelstruktur (2) im zweiten Bereich (A2) die ersten Isolierschichten (21) und Halbleiterschichten (22) umfasst, die abwechselnd entlang der vertikalen Richtung gestapelt sind, und wobei die auf jeder der isolierenden Stufen befindliche leitfähige Schicht (61) jeweils mit jeder der Halbleiterschichten (22) elektrisch verbunden ist.

## Revendications

1. Procédé de fabrication d'une structure semi-conductrice, comprenant :
fournir un substrat (1) et une structure empilée (2) située sur le substrat (1), la structure empilée (2) comprenant des premières couches isolantes (21) et des couches semi-conductrices (22) empilées de manière alternative dans une direction verticale, et la structure empilée (2) ayant une première région (A1) ;
graver des parties de la structure empilée (2) dans la première région (A1) jusqu'au substrat (1) pour former une pluralité de premières tranchées (41) agencées à intervalles et une pluralité de premières régions en escalier (10) situées entre les premières tranchées (41) ;
former des deuxièmes couches isolantes (42) dans les premières tranchées (41), la pluralité de premières régions en escalier (10) étant isolées les unes des autres par les deuxièmes couches isolantes (42) ;
graver la structure empilée (2) dans la pluralité de premières régions en escalier (10) dans la direction verticale pour former une première structure en escalier (31) ;
former des couches conductrices (61) à un sommet de la première structure en escalier (31) ; et
éliminer les couches semi-conductrices (22) sous les couches conductrices (61), et former des couches de support isolantes (64) remplissant un espace à partir duquel les couches semi-conductrices (22) sont éliminées, de sorte que les premières couches isolantes (21) et les couches de support isolantes (64) sous au moins l'une des couches conductrices (61) soient agencées de manière alternative dans la direction verticale, et que seules les premières couches isolantes (21) et les couches de support isolantes (64) sont situées entre ladite ou lesdites couches conductrices (61) et le substrat (1).

2. Procédé de fabrication d'une structure semi-conductrice selon la revendication 1, dans lequel la pluralité de premières régions en escalier (10) sont successivement d'une première région en escalier à une N-ième région en escalier dans une direction horizontale ; et la gravure de la structure empilée (2) dans la pluralité de premières régions en escalier (10) dans la direction verticale pour former la première structure en escalier (31) comprend :
graver successivement les premières régions en escalier (10) dans la direction horizontale et graver au moins une couche parmi les premières couches isolantes (21) et les couches semi-conductrices (22) dans les premières régions en escalier (10) pour former la première structure en escalier (31), une j-ième région en escalier étant gravée simultanément lorsque la première région en escalier jusqu'à la (j-1)-ième région en escalier sont gravées, où 1 < j ≤ N, et j et N sont des entiers supérieurs à 1.

3. Procédé de fabrication d'une structure semi-conductrice selon l'une quelconque des revendications 1 à 2, dans lequel la gravure des parties de la structure empilée (2) dans la première région (A1) jusqu'au substrat (1) comprend :
former une couche photorésistante sur une surface de la structure empilée (2), la couche photorésistante située dans la première région (A1) comportant des trous de gravure définissant des emplacements des premières tranchées (41) ;
graver la structure empilée (2) le long des trous de gravure pour former la pluralité de premières tranchées (41), les premières tranchées (41) étant réparties de manière régulière dans la première région (A1) dans la direction horizontale, et des surfaces des premières régions en escalier (10) entre deux tranchées (41) adjacente étant identiques ; et
éliminer la couche photorésistante.

4. Procédé de fabrication d'une structure semi-conductrice selon l'une quelconque des revendications 1 à 3, dans lequel la structure empilée (2) comprend en outre une deuxième région (A2) adjacente à la première région (A1), et la gravure de la structure empilée (2) dans la pluralité de premières régions en escalier (10) dans la direction verticale comprend :
former une couche de masque (52), la couche de masque (52) étant formée sur des surfaces des deuxièmes couches isolantes (42) et sur une surface de la deuxième région (A2) de la structure empilée (2) ; et
graver la structure empilée (2) dans la pluralité de premières régions en escalier (10) successivement dans la direction verticale avec la couche de masque (52) comme masque.

5. Procédé de fabrication d'une structure semi-conductrice selon la revendication 4, dans lequel la gravure successif de la structure empilée (2) dans la pluralité de premières régions en escalier (10) dans la direction verticale avec la couche de masque (52) comme masque comprend :
former une couche de blindage (51) sur des surfaces de la pluralité de premières régions en escalier (10) ; et
graver des parties de la couche de blindage (51) et conserver une partie de la couche de blindage (51) sur les surfaces des régions en escalier avant la gravure de la structure empilée (2) dans les premières régions en escalier (10).

6. Procédé de fabrication d'une structure semi-conductrice selon l'une quelconque des revendications 1 à 5, dans lequel la gravure de la structure empilée (2) dans la pluralité de premières régions en escalier (10) dans la direction verticale comprend : graver au moins une couche parmi les premières couches isolantes (21) et les couches semi-conductrices (22) de la structure empilée (2) dans chacune des premières régions en escalier (10) jusqu'à ce qu'une surface d'une couche semi-conductrice cible est exposée.

7. Procédé de fabrication d'une structure semi-conductrice selon l'une quelconque des revendications 1 à 6, dans lequel les couches semi-conductrices (22) sont des couches de silicium, et la formation des couches conductrices (61) au sommet de la première structure en escalier (31) comprend : déposer les couches conductrices (61) sur des surfaces de la première structure en escalier (31) ; ou
graver au moins une partie des couches de silicium sur les surfaces de la première structure en escalier (31) ; et déposer les couches conductrices (61) sur des surfaces des couches de silicium restantes dans la première structure en escalier (31) ; ou
effectuer un processus de métallisation sur les couches de silicium au sommet de la première structure en escalier (31) pour former les couches conductrices (61).

8. Procédé de fabrication d'une structure semi-conductrice selon l'une quelconque des revendications 1 à 7, comprenant en outre :
former des troisièmes couches isolantes (63) sur des surfaces des couches isolantes(61) ;
former, à l'intérieur des troisièmes couches isolantes (63) dans les régions en escalier, des trous traversants conducteurs exposant les couches conductrices (61) ; et
former des piliers conducteurs (62) à l'intérieur des trous traversants conducteurs, les piliers conducteurs étant connectés aux couches conductrices (61) par contact.

9. Procédé de fabrication d'une structure semi-conductrice selon l'une quelconque des revendications 1 à 8, dans lequel la structure empilée (2) comprend en outre une troisième région (A3) agencée à un intervalle de la première région (A1), et le procédé comprend en outre l'étape suivante simultanément lorsque les parties de la structure empilée (2) dans la première région (A1) sont gravées jusqu'au substrat (1) :
graver des parties de la structure empilée (2) dans la troisième région (A3) jusqu'au substrat (1) pour former une pluralité de deuxièmes tranchées (43) agencées à intervalles et une pluralité de deuxièmes régions en escalier situées entre les deuxièmes tranchées (43) ; et
le procédé comprend en outre l'étape suivante simultanément lorsque la structure empilée (2) dans la pluralité de premières régions en escalier (10) est gravée dans la direction verticale pour former la première structure en escalier (31) : graver la structure empilée (2) dans la pluralité de deuxièmes régions en escalier dans la direction verticale pour former une deuxième structure en escalier (32).

10. Procédé de fabrication d'une structure semi-conductrice selon l'une quelconque des revendications 1 à 9, dans lequel l'élimination des couches semi-conductrices (22) sous les couches conductrices (61) et la formation des couches de support isolantes (64) remplissant un espace à partir duquel les couches semi-conductrices (22) sont éliminées, comprennent :
former des rainures de gravure, les rainures de gravure exposant des surfaces latérales de la première structure en escalier (31) dans la structure empilée (2) ;
éliminer les couches semi-conductrices (22) dans la première structure en escalier (31) le long des rainures de gravure pour former des premiers espaces ; et
remplir les rainures de gravure et les premiers espaces pour former des couches de support isolantes (64).

11. Structure semi-conductrice, comprenant :
un substrat (1) et une structure empilée (2) située sur le substrat (1), la structure empilée (2) comprenant une première région (A1) ;
une structure isolante en escalier, la structure isolante en escalier étant située dans la première région (A1) et comprenant une pluralité d'escaliers isolants agencés à intervalles, et des hauteurs de deux escaliers isolants quelconques étant différentes, une hauteur de chaque escalier isolant correspondant à une distance entre une surface supérieure du substrat (1) et une surface supérieure de chaque escalier isolant ; et
des couches conductrices (61), les couches conductrices (61) étant situées sur les escaliers isolants, respectivement,
dans lesquelles l'escalier isolant sous au moins l'une des couches conductrices comprend des premières couches isolantes (21) et des couches de support isolantes (64) agencées de manière alternative dans une direction verticale, et seules les premières couches isolantes (21) et les couches de support isolantes (64) sont situées entre ladite ou lesdites couches conductrices (61) et le substrat (1) ;
**caractérisée en ce que** la structure semi-conductrice comprend en outre :
des deuxièmes couches isolantes (42), les deuxièmes couches isolantes (42) étant situées sur le substrat (1) et situées entre des escaliers isolants adjacents ; la pluralité d'escaliers isolants étant isolés les uns des autres par les deuxièmes couches isolantes.

12. Structure semi-conductrice selon la revendication 11, comprenant en outre:
une pluralité de piliers conducteurs (62), la pluralité de piliers conducteurs (62) étant connectés électriquement aux couches conductrices (61), respectivement.

13. Structure semi-conductrice selon la revendication 11 ou 12, dans laquelle la structure empilée (2) comprend une deuxième région (A2) adjacente à la première région (A1), la structure empilée (2) dans la deuxième région (A2) comprend les premières couches isolantes (21) et les couches semi-conductrices (22) empilées de manière alternative dans la direction verticale, et la couche conductrice (61) située sur chacune des escaliers isolants est connectée électriquement à chacune des couches semi-conductrices (22).
